# FASCICULE DE BREVET EUROPEEN

(11) **EP 2 530 755 B1**
(45) Date de publication et mention de la délivrance du brevet: **26.03.2014**
(21) Numéro de dépôt: 12168677.8
(22) Date de dépôt: 21.05.2012
(51) Int. Cl.: H01L 41/047, H01L 41/29, H01L 41/08

(54) **Composant électrique comprenant un matériau de structure pérovskite et des électrodes optimisées et procédé de fabrication**
Elektrisches Bauteil umfassend ein Material mit einer Perowskitstruktur und optimierte Elektroden sowie entsprechendes Herstellungverfahren
Electrical component comprising a material with perovskite structure and optimised electrodes and method for manufacturing same

(30) Priorité: 01.06.2011 FR 1154813
(43) Date de publication de la demande: 05.12.2012
(73) Titulaire: COMMISSARIAT A L'ENERGIE ATOMIQUE ET AUX ENERGIES ALTERNATIVES, 75015 Paris (FR)
(72) Inventeur: Cueff, Matthieu, 38000 GRENOBLE (FR); Defay, Emmanuel, 38340 VOREPPE (FR); Le Rhun, Gwenaël, 38140 RENAGE (FR)
(74) Mandataire: Esselin, Sophie

(56) Documents cités:
- US-A1- 2009 273 654
- US-A1- 2010 141 099

## Description

Le domaine de l'invention est celui des composants électriques à base de matériau piézoélectrique et ferroélectrique pouvant avantageusement être utilisés dans des dispositifs de type actionneur.

Il existe de nombreux matériaux présentant des propriétés piézoélectriques. Les plus connus sont le Nitrure d'Aluminium (AIN), l'Oxyde de Zinc (ZnO) ou encore le Titano-Zirconate de Plomb (PZT). Ce dernier fait partie d'une grande famille de matériaux dont la structure cristalline est particulière. Il s'agit de la classe des matériaux « pérovskites ». Cette structure est à l'origine des propriétés piézoélectriques et ferroélectriques de ce type de matériaux, basés sur une structure de type « ABO₃ ». Parmi les matériaux les plus utilisés, on retrouve la plupart du temps l'atome de Plomb sur le site A de la maille.

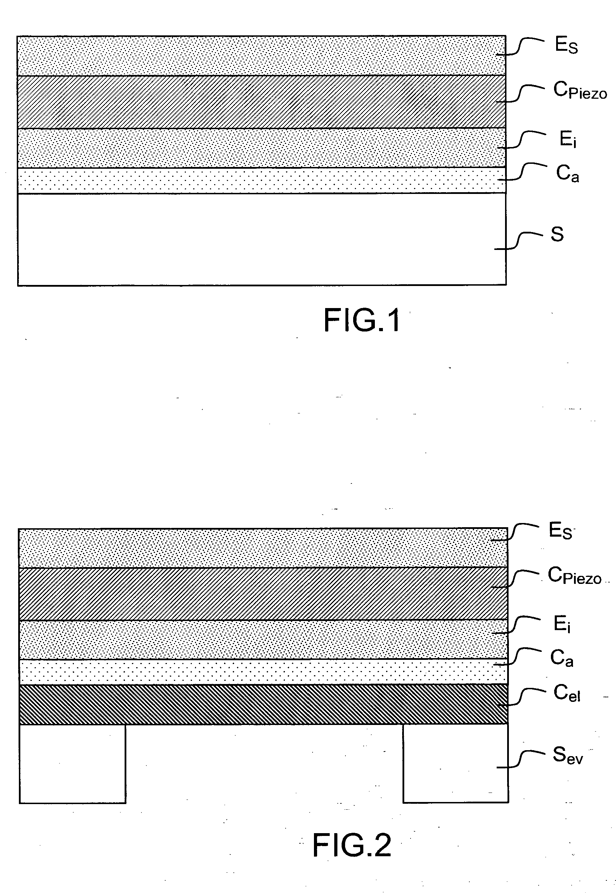

De manière schématisée, un composant électrique à base de matériau pérovskite peut comprendre comme illustré en figure 1, l'empilement de couches suivantes à la surface d'un substrat S : une couche de matériau C_{piézo}, comprise entre une électrode inférieure Eᵢ et une électrode supérieure Eₛ. Pour la croissance des matériaux à base de Plomb, il est connu d'utiliser du Platine car celui-ci favorise la croissance du matériau déposé dans sa phase pérovskite. Pour favoriser l'adhérence du Platine sur la couche en-dessous (généralement de l'Oxyde de Silicium), on peut utiliser une couche d'accroche Cₐ. Les couches d'accroche les plus communes sont le Titane, l'Oxyde de Titane, le Tantale ou encore le Titanate de Strontium.

On peut déposer une électrode supérieure sur le matériau actif de façon à réaliser une capacité Métal-lsolant-Métal. Cette électrode peut être en Platine, Ruthénium, Oxyde de Ruthénium, Iridium, Oxyde d'Iridium, Tungstène, etc.

Cette électrode supérieure peut aussi être structurée de façon à former des peignes interdigités pour actionner le matériau actif dans le plan.

Il existe deux grands types d'empilements pour réaliser des composants, selon le type d'applications visées.

Un premier type, appelé empilement « bulk » : dans cet empilement, toutes les couches sont déposées sur le substrat. Celui-ci reste épais par rapport au reste des couches. De cette façon, les déplacements induits par le matériau piézoélectrique sont limités et couplés à ceux du substrat. C'est ce type d'empilement qui est utilisé lorsque l'on souhaite réaliser des composants qui n'ont pas de partie mobile comme illustré en figure 1. A la surface d'un substrat S, sont disposées successivement une couche d'accroche Cₐ, une électrode inférieure Eᵢ en Platine, la couche de matériau actif C_{piézo} de matériau pérovskite à base de Plomb et une électrode supérieure Eₛ.

Ce type d'empilement peut être utilisé pour réaliser des capacités « tunable » ou encore des mémoires ferroélectriques « FeRAM ». On utilise dans ce cas les propriétés ferroélectriques et diélectriques du matériau actif.

Lorsque l'on souhaite utiliser une partie mobile dans le composant, pour utiliser l'effet piézoélectrique par exemple, on vient réduire l'épaisseur du composant dans la zone active et plus précisément de la ou des couches disposées sous la zone active de façon à libérer le mouvement d'une membrane ou d'un cantilever par exemple. Un schéma d'un tel empilement est illustré en figure 2 qui met en évidence l'empilement suivant sur un substrat évidé Sₑᵥ: une couche élastique Cₑₗ, une couche d'accroche Cₐ, une électrode inférieure Eᵢ, la couche active C_{piézo}, une électrode supérieure Eₛ.

Ce type d'empilement est utilisé pour réaliser des capteurs, des actionneurs ou encore des résonateurs. Cet empilement est utilisé pour des applications « piézoélectriques ».

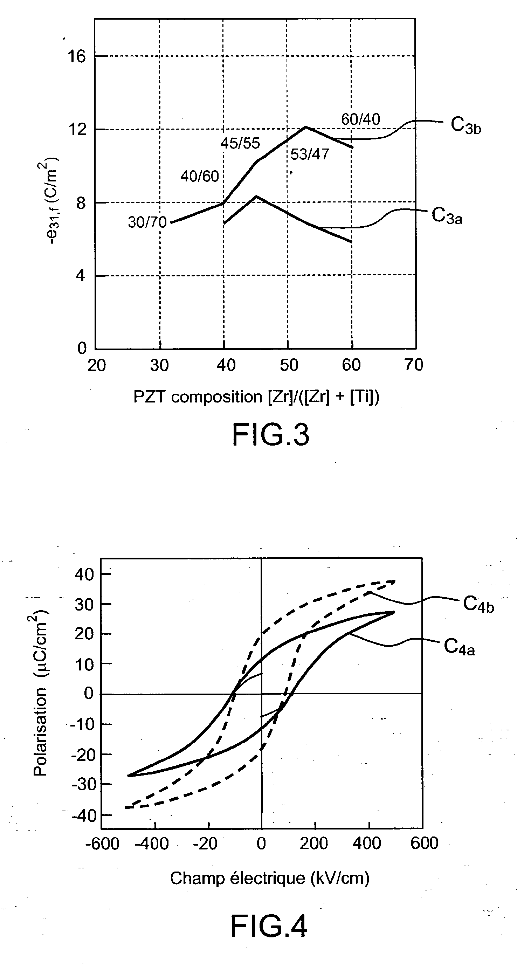

Les matériaux pérovskites sont complexes et peuvent présenter plusieurs phases avec différentes orientations. Par exemple, le PZT peut être cristallisé en phase quadratique, rhomboédrique, monoclinique ou dans un mélange de ces différentes phases (composition morphotropique). Les propriétés piézoélectriques du PZT dépendent de sa composition et de son orientation. Cette dépendance est illustrée en figure 3 (Recent Progress in Materials Issues for Piezoelectric MEMS, P. Muralt, Journal of the American Society, vol. 91, no. 5, 2008, pp. 1385-1396.)..

L'abscisse de la figure 3 représente la composition, c'est-à-dire le ratio Zr/Ti du matériau. En ordonnée, on représente la valeur du coefficient e_{31,f}, qui correspond aux propriétés piézoélectriques des films minces de PZT. Pour la partie riche en Ti, le PZT est cristallisé dans sa phase quadratique. Pour la partie riche en Zr, le PZT est cristallisé dans sa phase rhomboédrique. Pour un ratio Zr/Ti proche de 52/48, le PZT est cristallisé suivant un mélange de ces deux phases et de la phase monoclinique (phase morphotropique). Les propriétés piézoélectriques sont maximales au voisinage de cette composition. La courbe C₃ₐ est relative au matériau texturé suivant l'orientation (111), la courbe C_{3b} est relative au matériau texturé suivant l'orientation (100). Les propriétés piézoélectriques sont meilleures pour l'orientation (100) que pour l'orientation (111).

Sur la figure 4 (Preparation of (100)- and (111)-Textured Pb(Zr,Ti)03 Piezoelectric Films and Direct Measurement of Their Piezoelectric Constants, W. Gong, J.-F. Li, X. Chu, Z. Gui, L. Li, Japanese Journal of Applied Physics, Vol.42, 2003, pp. 1459-1461.), les cycles d'hystérésis de la polarisation sont tracés en fonction du champ électrique appliqué dans le matériau, pour une même composition (MPB :niobate de lithium ou de tantalate de lithium, pour deux orientations différentes. La courbe C₄ₐ est relative au matériau texturé suivant l'orientation (100), la courbe C_{4b} est relative au matériau texturé suivant l'orientation (111). Le comportement ferroélectrique du matériau est ainsi dépendant de la texturation du matériau. L'orientation (111) présente une polarisabilité plus importante.

Pour les mémoires FeRAM, il a été montré que l'orientation (111) du PZT était la plus intéressante, car c'est celle qui permet d'avoir la polarisation rémanente la plus élevée, pour une composition de PZT donnée, tel que décrit dans « High Temperature Deposition of Pt/TiOₓ for Bottom Electrodes, brevet US 6682772B1, 27 Janvier 2004 et illustré en figure 4.

Pour les applications piézoélectriques, les meilleures propriétés sont obtenues pour l'orientation (100) du PZT. Ces résultats ont été rapportés par les équipes de P. Muralt, « Recent Progress in Materials Issues for Piezoelectric MEMS », P. Muralt, Journal of the American Society, vol. 91, no. 5, 2008, pp. 1385-1396.et S. Trolier-McKinstry, "Thin Film Piezoelectric for MEMS", S. Trolier-McKinstry, P. Muralt, Journal of Electroceramics, vol. 12, 2004, pp. 7-17.

Le demandeur a pu observer la supériorité de l'orientation (100) par rapport à l'orientation (111) sur le coefficient piézoélectrique transverse d_{31.}

Pour contrôler l'orientation du PZT, on peut utiliser une couche de germination. Il a été montré par P. Muralt qu'une fine couche de TiO₂ déposée sur le Platine permettait d'obtenir l'orientation (111), comme décrit dans l'article : « Texture control of PbTiO3 and Pb(Zr,Ti)O3 thin films with Ti02 seeding », P. Muralt, T. Maeder, L. Sagalowicz, S. Hiboux, S. Scalese, D. Naumovic, R.G. Agostino, N. Xanthopoulos, H.J. Mathieu, L. Patthey, E.L. Bullock, Journal of Applied Physics, Vol. 83, no. 7, 1998, pp. 3835-3841.

Il a aussi été montré par la même équipe et décrit dans l'article « Textured, piezoelectric Pb(Zrx,Ti1-x)O3 thin films for MEMS: integration, deposition and properties » N. Ledermann, P. Muralt, J. Baborowski, S. Gentil, K. Mukati, M. Cantoni, A. Seifert, N. Setter, Sensors and Actuators A, vol. 105, 2003, pp. 162-170, qu'une fine couche de PbO favorisait l'orientation (100).

Pour expliquer ces différences, la diffusion du Plomb est en partie contrôlée par la couche de germination, le stress du Platine ainsi que les matériaux composants la couche d'accroche lors de début de la cristallisation. Il est en effet connu que la cristallisation de ce type de couche est dépendante de l'interface car il s'agit d'un mécanisme de cristallisation limitée par la croissance des grains.

Une autre équipe (G. Fox, Ramtron) utilise une première couche avec un fort excès de plomb (30%) ainsi qu'un recuit à faible température pour favoriser la croissance (111), comme décrit dans le brevet US 6287637B1 « Multi-layer approach for optimizing ferroelectric film performance ».

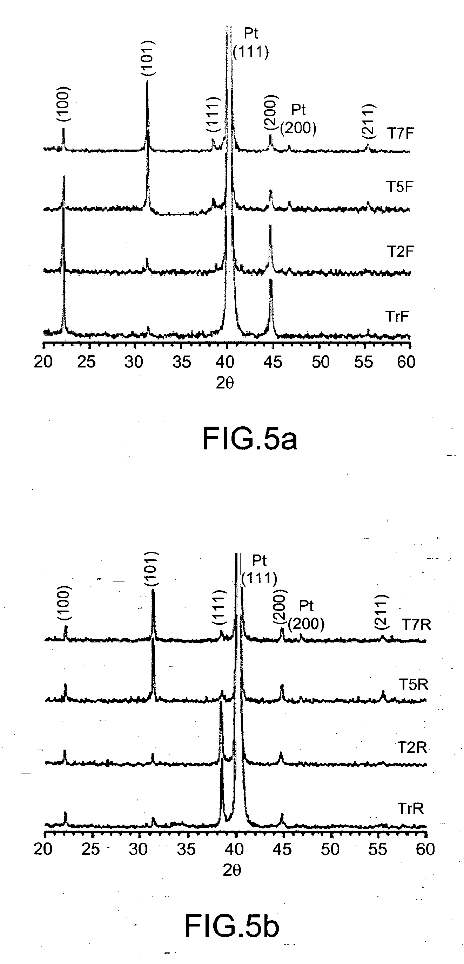

La figure 5 (Effects of adhesion layer (Ti or Zr) and Pt deposition temperature on the properties of PZT thin films deposited by RF magnetron sputtering, Mardare C.C., Joanni E., Mardare A.I., Fernandes J.R.A., de Sa C.P.M., Tavares P.B., Applied Surface Science, Volume 243, 2005, pp. 113-124.) présente les résultats d'une étude faisant varier la température de dépôt du Platine ainsi que le mode de recuit de cristallisation du PZT (avec un four classique illustré en figure 5a et avec un four à recuit rapide dénommé « RTA » illustré en figure 5b). La cristallisation du PZT est fortement dépendante de ces deux paramètres. Ainsi, sur du Platine déposé à température ambiante, si le PZT est recuit dans un four il est cristallisé suivant l'orientation (100) alors que s'il est recuit dans un four « RTA », il est cristallisé suivant l'orientation (111). Les courbes d'ordonnées croissantes correspondent respectivement à des températures de dépôt du Pt à 25°C, 2006°C, 500°C et 700°C.

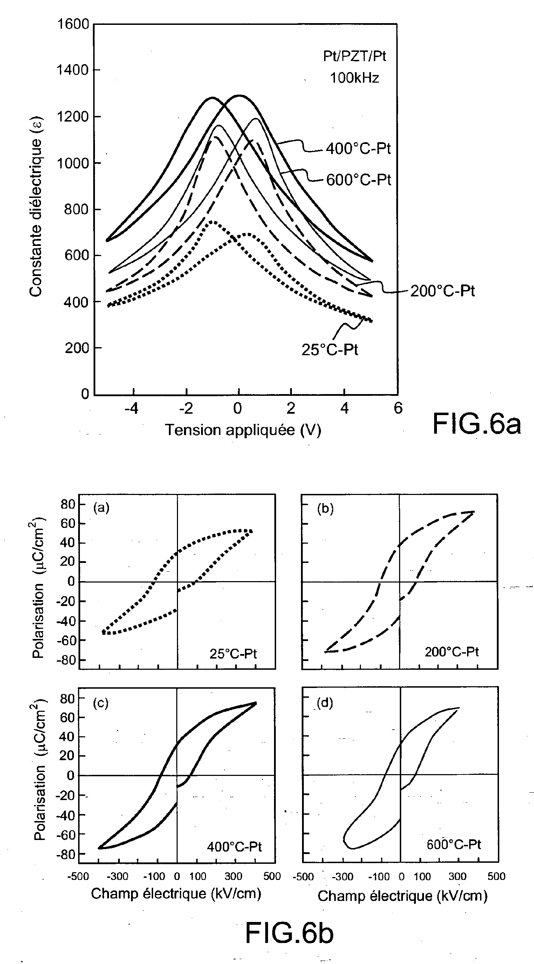

La figure 6 (Pt-base electrodes and effects on phase formations and electrical properties of high-dielectric thin films, Lee W.-J., Kim Y.-M., Kim H.G., Thin Solid Films, Volume 269, 1995, pp. 75-79.) présente les propriétés diélectriques et ferroélectriques du PZT en fonction de la température de dépôt du Platine. Les courbes d'hystérésis de la figure 6a sont relatives à la permittivité alors que la celles de la figure 6b sont relatives à la polarisation, celles-ci sont meilleures lorsque la température de dépôt du Platine augmente. Il apparait alors un optimum autour de 400°C maximisant les propriétés diélectriques et ferroélectriques du PZT.

Il est aussi connu que la température de dépôt du Platine comme électrode inférieure peut avoir un impact sur la fiabilité du film actif.

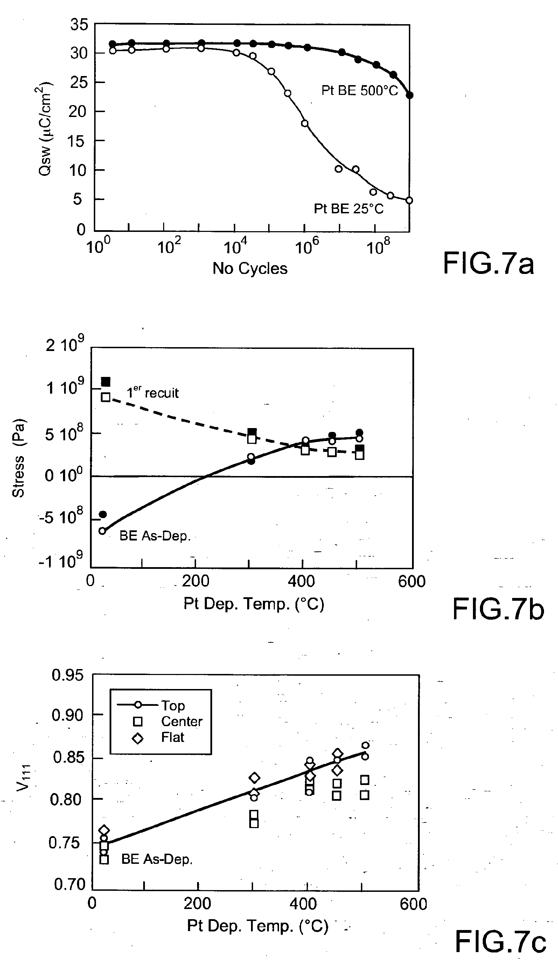

La figure 7a montre la dépendance entre la température de dépôt du Platine et la tenue de la polarisation du PZT lors d'un cyclage. La polarisation se dégrade moins vite si le Platine est déposé à 500°C que si le Platine est déposé à 25°C. La figure 7b montre la dépendance de la contrainte résiduelle (appelée également stress) dans la couche de Platine avant et après le recuit de cristallisation du PZT en fonction de la température de dépôt du Platine. Plus le Platine est déposé à température élevée, plus la contrainte résiduelle dans la couche de Pt sera faible après recuit de cristallisation du PZT. Enfin, la figure 7c présente la dépendance de la fraction de PZT cristallisé (111) en fonction de la température de dépôt du Platine. Plus le Platine est déposé à température élevée, plus le PZT sera cristallisé suivant l'orientation (111). Les figures 7 sont extraites de : High Temperature Deposition of Pt/TiOx for Bottom Electrodes, dépôt de brevet US 6682772B1, 27 Janvier 2004.

US 2007/0273654 A1 divulgue un composant électrique comprenant une électrode inférieure comportant une première couche de stabilisation en un premier matériau et une seconde couche de germination en un second matériau, le premier et le second matériaux étant métallique et présentant des paramètres de structuration et une densité différents.

La contrainte dans la couche de Platine servant d'électrode inférieure est donc un paramètre déterminant pour contrôler l'orientation de la couche de PZT qui croit dessus.

Il ressort ainsi de l'ensemble des connaissances de l'homme du métier que la température de dépôt du Platine influence la croissance des couches pérovskites à base de Plomb.

Le Demandeur a déjà constaté que le Platine déposé à 25°C permettait d'obtenir du PZT orienté (100) alors que du Platine déposé à 450°C permettait d'obtenir du PZT orienté (111). Cette différence peut être liée à la diffusion du Plomb dans les couches inférieures de l'empilement.

Par ailleurs pour les actionneurs, l'orientation (100) est la plus favorable.

La température de dépôt du Platine influence aussi les propriétés du matériau pérovskite. Il semble que les propriétés diélectriques et ferroélectriques soient moins bonnes sur du Platine déposé à 25°C que sur du Platine déposé à 450°C. De même, le dépôt du Platine en température permet de limiter le vieillissement de la polarisabilité du PZT.

Il a été montré dans l'état de l'art que le Platine déposé à 25°C permettait d'obtenir l'orientation (100) du matériau pérovskite à base de Plomb. Il a aussi été montré que du Platine déposé à basse température entrainait une baisse des propriétés ferroélectriques et diélectriques ainsi qu'un vieillissement de la couche ferroélectrique plus important. De façon plus générale, il a aussi été montré que la contrainte dans le Platine variait au cours du recuit de cristallisation si ce dernier n'était pas recuit à la température de cristallisation du matériau actif. Par contre, si l'on dépose du PZT directement sur du Platine recuit à la température du recuit de cristallisation du PZT, les propriétés du PZT sont moins bonnes, l'optimum de température de dépôt du Platine se situant vers 450°C.

Le problème que cherche à résoudre la présente invention est d'obtenir l'orientation souhaitée du matériau sans pour autant diminuer ses propriétés ni augmenter son vieillissement.

C'est pourquoi et dans ce contexte, le Demandeur propose un nouveau type de composant électrique à base de matériau pérovskite comprenant deux couches de Platine pour former l'électrode inférieure, chaque couche assurant une fonction différente tout en étant réalisé avec une nature de métal identique, le platine par exemple.

Plus précisément la présente invention a pour objet un composant électrique comprenant une couche de matériau de cristal pérovskite à base de plomb comprise entre une électrode inférieure à la surface d'un substrat et une électrode supérieure, **caractérisé en ce que** l'électrode inférieure comporte une première couche de stabilisation en un premier matériau et une seconde couche de germination en un second matériau, le premier et le second matériaux étant de même composition chimique mais présentant des paramètres de structuration et/ou une densité, différents.

On entend par même nature de matériaux, le fait que le premier et le second matériaux ont la même composition chimique mais pas la même structure. Les paramètres de structuration sont par exemple la taille des grains, la rugosité de surface ou encore la texturation du matériau (qualité de l'orientation cristalline préférentielle). Selon l'invention ces paramètres sont supérieurs pour le premier matériau à ceux du second matériau. La taille des grains et la rugosité de surface sont plus importants pour le premier matériau que pour le second. La densité des premier et second matériaux sont fonction de la température de dépôt, le premier matériau est plus dense que le second matériau Selon l'invention, le substrat peut être un support homogène ou hétérogène.

Selon une variante de l'invention, la première couche de stabilisation est en contact avec la seconde couche de germination.

Selon une variante de l'invention, le matériau pérovskite est l'un des matériaux suivants : PZT dopé ou non, PbZrO₃, PbTiO₃, Pb(Mn,Nb)O₃, Pb(Mn,Nb)O3-PbTiO3.

Selon une variante de l'invention, la première couche de stabilisation et la seconde couche de germination de l'électrode inférieure sont respectivement en platine.

Selon une variante de l'invention, le matériau pérovskite est du PZT d'orientation cristallographique (111).

Selon une variante de l'invention, le matériau pérovskite est du PZT d'orientation cristallographique (100).

L'invention a aussi pour objet un actionneur comprenant un composant électrique selon l'invention, dans lequel le substrat comprend au moins une partie évidée de manière à définir une zone libérée pouvant se déformer comportant la couche de matériau pérovskite.

Selon une variante de l'invention, l'actionneur comprend en outre une couche élastique à la surface du substrat sur laquelle est déposée la couche de stabilisation, positionnée au moins au-dessus de la partie évidée.

Selon une variante de l'invention, la couche élastique est en silicium, ou en oxyde de silicium, ou en nitrure de silicium.

L'invention a encore pour objet un procédé de fabrication d'un composant selon l'invention, comprenant la réalisation à température de cristallisation donnée, d'une couche de matériau pérovskite entre une électrode inférieure et une électrode supérieure, ladite réalisation d'électrode inférieure comportant les étapes suivantes :
- la réalisation d'une première couche de stabilisation effectuée par dépôt de platine à une première température maximum T1 ;
- la réalisation d'une seconde couche de germination effectuée par dépôt de platine à une seconde température T2 maximum, inférieure à la température T1 et à la température de cristallisation du matériau pérovskite.

Les températures T1 et T2 correspondent aux températures maximum vues par le platine au cours de son dépôt ou éventuellement après son dépôt (par exemple recuit) mais dans tous les cas avant le dépôt sur le platine d'une autre couche. Par ailleurs, la température de cristallisation utilisée selon le procédé de l'invention est supérieure ou égale à la température minimum nécessaire pour obtenir ladite cristallisation dudit matériau (défini dans les abaques).

Selon une variante de l'invention, la première température T1 est supérieure ou égale à la température de cristallisation du matériau pérovskite. Il s'agit dans ce cas d'un mode préférentiel bien que dans certain cas la température T1 puisse être légèrement inférieure à la température de cristallisation.

Selon une variante de l'invention, le matériau pérovskite étant du PZT d'orientation (100) dont la température de cristallisation est supérieure ou égale 500°C;
- la réalisation d'une première couche de stabilisation est effectuée par dépôt de platine à une première température T1 maximum de l'ordre de 700°C;
- la réalisation d'une seconde couche servant de couche de germination est effectuée par dépôt de platine à une seconde température T2 maximum inférieure à environ 200°C (et préférentiellement de l'ordre de 25 °C).

Selon une variante de l'invention, le matériau pérovskite étant du PZT d'orientation (111) dont la température de cristallisation est supérieure ou égale 500°C;
- la réalisation d'une première couche de stabilisation est effectuée par dépôt de platine à une première température T1 maximum de l'ordre de 700°C;
- la réalisation d'une seconde couche de germination est effectuée par dépôt de platine à une seconde température T2 maximum inférieure à environ 500°C (et préférentiellement de l'ordre de 450°C).

Selon une variante de l'invention, la première couche est réalisée à une température de dépôt et recuite à une température de recuit, par exemple la température de dépôt peut être de 450°C, la température de recuit pouvant être de 700°C.

L'invention sera mieux comprise et d'autres avantages apparaîtront à la lecture de la description qui va suivre donnée à titre non limitatif et grâce aux figures annexées parmi lesquelles :
- la figure 1 illustre un empilement standard d'un composant utilisant une couche pérovskite à base de Plomb et pouvant être utilisé dans un composant de type « bulk » ;
- la figure 2 illustre un composant comportant un substrat dit « libéré » et l'empilement illustré en figure 1 ;
- la figure 3 illustre la dépendance des propriétés piézoélectriques (e₃₁) du PZT en fonction de sa composition et de son orientation ;
- la figure 4 illustre la dépendance de la polarisation en fonction de l'orientation du PZT ;
- les figures 5a et 5b illustrent les dépendances de la température de dépôt du Platine et du type de recuit de cristallisation du PZT dans le cas d'une opération de recuit classique et dans le cas d'un recuit RTA ;
- les figures 6a et 6b illustrent les dépendances des propriétés ferroélectriques en PZT en fonction de la température de dépôt du Platine ;
- les figures 7a, 7b, 7c illustrent respectivement la dépendance entre la température de dépôt du Pt et la tenue de la polarisation du PZT lors d'un cyclage, la dépendance du stress dans la couche de Pt avant et après le recuit de cristallisation du PZT en fonction de la température de dépôt du Pt, la dépendance de la fraction de PZT cristallisé (111) en fonction de la température de dépôt du Platine ;
- la figure 8 illustre un exemple d'empilement de couches utilisé dans un composant électrique selon l'invention ;
- les figures 9a et 9b illustrent deux exemples d'actionneurs de type membrane et cantilever comprenant un composant selon la présente invention.

De manière générale, le composant électrique de la présente invention comporte une couche de matériau pérovskite entre une électrode inférieure à la surface d'un substrat et entre une électrode supérieure.

L'électrode inférieure est optimisée et comprend une structure bi-couche. Une première couche inférieure dite de stabilisation est déposée à une température inférieure ou égale à la température T1. Lorsque, le composant de l'invention comporte une couche d'accroche en Titane, pour éviter la diffusion du Titane dans cette première couche, cette dernière est déposée en utilisant 2 températures, une température de dépôt proprement dite et une température de recuit supérieure à la température de dépôt et égale à T1.

La température maximale de dépôt ou de recuit T1 est supérieure à la température de cristallisation du matériau pérovskite déposé dans une étape ultérieure. On choisit ainsi cette température de façon à stabiliser la couche de Platine inférieure.

On dépose dans un second temps, une seconde couche de Platine supérieure dite de germination. Ainsi, on peut utiliser une couche déposée à température ambiante pour favoriser l'orientation (100) ou une couche déposée à 450°C pour favoriser l'orientation (111) dans le cas du PZT.

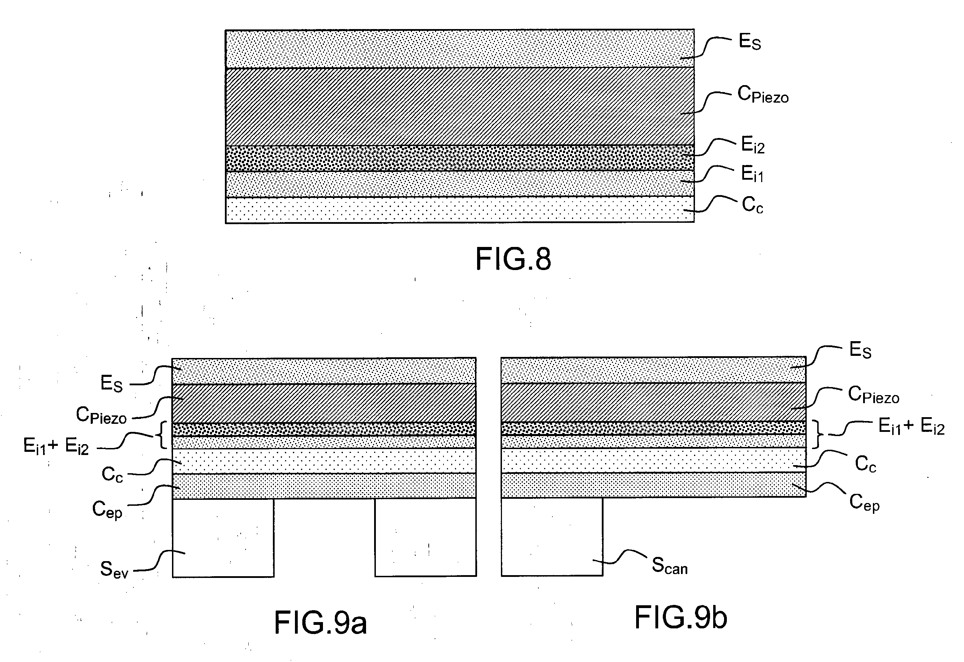

La figure 8 représente un exemple d'empilement de couches utilisé dans un composant électrique selon l'invention, ledit empilement comprenant :
- une couche d'accrochage C_{c};
- une première électrode inférieure Eᵢ₁ assurant une fonction de stabilisation ;
- une seconde électrode inférieure Eᵢ₂ assurant une fonction de texturation encore dénommée de germination ;
- une couche de matériau pérovskite C_{piézo};
- une seconde électrode supérieure Eₛ.

Contrairement aux solutions de l'art connu qui proposent pour favoriser les orientations (100) et (111) du PZT d'utiliser une couche de germination déposée sur le Platine en matériau diélectrique par exemple TiO₂ ou PbO, la présente invention propose d'utiliser une couche dite de texturation encore désignée couche de germination, en Platine.

On peut alors de manière classique réaliser la couche de cristal pérovskite en PZT C_{piezo}, puis procéder au dépôt de l'électrode supérieure Eₛ.

### Exemple de procédé de fabrication d'une telle structure avec du PZT:

Les deux épaisseurs de Platine de l'électrode inférieure sont déposées par pulvérisation cathodique (PVD). La première couche est déposée à 450°C puis recuite sur une « hotplate » à 700°C. La seconde couche est déposée à 25 °C. L'épaisseur des deux couches totale est de100 nm, chaque couche ayant une épaisseur de 50 nm, néanmoins tous les ratios sont possibles.

Le PZT est ensuite déposé par méthode sol-gel et cristallisé à 700°C. Le PZT fait 2 µm d'épaisseur.

### Une électrode supérieure en Ru est ensuite déposée par pulvérisation cathodique (PVD) sur le PZT. L'électrode supérieure fait 100 nm d'épaisseur.

### Exemple de réalisation d'actionneurs selon l'invention

Comme illustré en figure 9a, l'actionneur selon l'invention comprend une membrane définie grâce à la réalisation d'un substrat évidé Sₑᵥ, à la surface duquel sont réalisés une couche élastique et l'empilement de couches décrit en figure 8.

Plus précisément, l'actionneur comprend à la surface du substrat partiellement évidé :
- une couche élastique Cₑₗ;
- une couche d'accroche C_{c};
- une première couche en Platine Eᵢ₁;
- une seconde couche en Platine E_{i2;}
- une couche de PZT, C_{piézo} ;
- une couche d'électrode supérieure Eₛ.

Typiquement la couche d'accroche peut présenter une épaisseur de l'ordre de 1 nm à 50nm.

La couche élastique peut être en silicium, en oxyde de silicium, en nitrure de silicium et présenter une épaisseur de l'ordre d'une centaine de nanomètres à une dizaine de microns.

Avantageusement, la couche de matériau PZT est d'orientation (100), la couche de stabilisation d'électrode en Platine est réalisée à plus de 300 °C, typiquement déposée à 450 °C puis recuite à 700 °C et la couche de germination en Platine est réalisée à 25°C.

Les épaisseurs de ces couches sont respectivement de 50 nm.

Une variante d'actionneur selon l'invention est illustré en figure 9b, dans laquelle, l'actionneur comporte une poutre à la surface d'un substrat S_{can}, ladite poutre étant réalisée par l'empilement de couches suivant :
- une couche élastique Cₑₗ ;
- une couche d'accroche C_{c} ;
- une première couche en Platine Eᵢ₁ ;
- une seconde couche en Platine Eᵢ₂ ;
- une couche de PZT, C_{piézo} ;
- une couche d'électrode supérieure Es de 100 nm d'épaisseur.

## Revendications

1. Composant électrique comprenant une couche de matériau de cristal pérovskite à base de plomb comprise entre une électrode inférieure (Eᵢ) à la surface d'un substrat (S) et une électrode supérieure (Eₛ), l'électrode inférieure comportant une première couche de stabilisation (Eᵢ₁) en un premier matériau et une seconde couche de germination (Eᵢ₂) en un second matériau, **caracterisé en ce que** le premier et le second matériaux étant de même composition chimique mais présentant des paramètres de structuration et/ou une densité, différents.

2. Composant électrique selon la revendication 1, **caractérisé en ce que** la première couche de stabilisation est en contact avec la seconde couche de germination.

3. Composant électrique selon l'une des revendications 1 ou 2, **caractérisé en ce que** le matériau pérovskite est l'un des matériaux suivants : PZT dopé ou non, PbZrO₃, PbTiO₃, Pb(Mn,Nb)O₃, Pb(Mn,Nb)O₃-PbTiO₃.

4. Composant électrique selon l'une des revendications 1 à 3, **caractérisé en ce que** la première couche de stabilisation et la seconde couche de germination de l'électrode inférieure sont respectivement en platine.

5. Composant électrique selon l'une des revendications 1 à 4, **caractérisé en ce que** le matériau pérovskite est du PZT d'orientation cristallographique (111).

6. Composant électrique selon l'une des revendications 1 à 4, **caractérisé en ce que** le matériau pérovskite est du PZT d'orientation cristallographique (100).

7. Actionneur comprenant un composant électrique selon l'une des revendications 1 à 6, dans lequel le substrat comprend au moins une partie évidée de manière à définir une zone libérée pouvant se déformer comportant la couche de matériau pérovskite.

8. Actionneur selon la revendication 7, **caractérisé en ce qu'**il comprend en outre une couche élastique à la surface du substrat sur laquelle est déposée la couche de stabilisation, positionnée au moins au-dessus de la partie évidée.

9. Actionneur selon la revendication 8, **caractérisé en ce que** la couche élastique est en silicium, ou en oxyde de silicium, ou en nitrure de silicium.

10. Procédé de fabrication d'un composant selon l'une des revendications 1 à 7, comprenant la réalisation à température de cristallisation donnée, d'une couche de matériau pérovskite entre une électrode inférieure et une électrode supérieure, ladite réalisation d'électrode inférieure comportant les étapes suivantes :
- la réalisation d'une première couche de stabilisation effectuée par dépôt de platine à une première température maximum (T1) ;
- la réalisation d'une seconde couche de germination effectuée par dépôt de platine à une seconde température (T2) maximum, inférieure à la première température (T1) et à la température de cristallisation du matériau pérovskite.

11. Procédé de fabrication d'un composant selon la revendication 10, **caractérisé en ce que** la première température (T1) est supérieure ou égale à la température de cristallisation du matériau pérovskite.

12. Procédé de fabrication d'un composant selon l'une des revendications 10 ou 11, **caractérisé en ce que** le matériau pérovskite étant du PZT d'orientation (100) dont la température de cristallisation est supérieure ou égale 500°C;
- la réalisation d'une première couche de stabilisation est effectuée par dépôt de platine à une première température (T1) maximum de l'ordre de 700 °C ;
- la réalisation d'une seconde couche servant de couche de germination est effectuée par dépôt de platine à une seconde température (T2) maximum inférieure à environ 200°C, pouvant être de l'ordre de 25°C.

13. Procédé de fabrication d'un composant selon la revendication 10, **caractérisé en ce que** le matériau pérovskite étant du PZT d'orientation (111) dont la température de cristallisation est supérieure ou égale 500°C;
- la réalisation d'une première couche de stabilisation est effectuée par dépôt de platine à une première température (T1) maximum de l'ordre de 700°C ;
- la réalisation d'une seconde couche de germination est effectuée par dépôt de platine à une seconde température (T2) maximum inférieure à environ 500°C, pouvant être de l'ordre de 450°C.

14. Procédé de fabrication d'un composant selon l'une des revendications 10 à 13, **caractérisé en ce que** la première couche est réalisée à une température de dépôt et recuite à une température de recuit.

15. Procédé de fabrication d'un composant selon la revendication 14, **caractérisé en ce que** la température de dépôt est de 450°C, la température de recuit étant de 700°C.

## Patentansprüche

1. Elektrische Komponente, die eine Schicht aus Perowskitkristallmaterial auf Bleibasis zwischen einer unteren Elektrode (Eᵢ) auf der Oberfläche eines Substrats (S) und einer oberen Elektrode (Eₛ) umfasst, wobei die untere Elektrode eine erste Stabilisierungsschicht (Eᵢ₁) aus einem ersten Material und eine zweite Keimungsschicht (Eᵢ₂) aus einem zweiten Material umfasst, **dadurch gekennzeichnet, dass** das erste und das zweite Material dieselbe chemische Zusammensetzung, aber unterschiedliche Strukturierungsparameter und/oder Dichten haben.

2. Elektrische Komponente nach Anspruch 1, **dadurch gekennzeichnet, dass** die erste Stabilisierungsschicht mit der zweiten Keimungsschicht in Kontakt ist.

3. Elektrische Komponente nach Anspruch 1 oder 2, **dadurch gekennzeichnet, dass** das Perowskitmaterial eines der folgenden Materialien ist: dotiertes oder undotiertes PZT, PbZrO₃, PbTiO₃, Pb(Mn,Nb)O₃, Pb(Mn,Nb)O₃-PbTiO₃.

4. Elektrische Komponente nach einem der Ansprüche 1 bis 3, **dadurch gekennzeichnet, dass** die erste Stabilisierungsschicht und die zweite Keimungsschicht der unteren Elektrode jeweils aus Platin bestehen.

5. Elektrische Komponente nach einem der Ansprüche 1 bis 4, **dadurch gekennzeichnet, dass** das Perowskitmaterial aus PZT mit der kristallografischen Orientierung (111) gefertigt ist.

6. Elektrische Komponente nach einem der Ansprüche 1 bis 4, **dadurch gekennzeichnet, dass** das Perowskitmaterial aus PZT mit der kristallografischen Orientierung (100) gefertigt ist.

7. Aktuator, der eine elektronische Komponente nach einem der Ansprüche 1 bis 6 umfasst, wobei das Substrat wenigstens einen ausgesparten Teil aufweist, um eine freie Zone zu definieren, die sich verformen kann und die die Perowskitmaterialschicht aufweist.

8. Aktuator nach Anspruch 7, **dadurch gekennzeichnet, dass** er ferner eine elastische Schicht auf der Oberfläche des Substrats umfasst, auf der die Stabilisierungsschicht abgesetzt ist, positioniert mindestens oberhalb des ausgesparten Teils.

9. Aktuator nach Anspruch 8, **dadurch gekennzeichnet, dass** die elastische Schicht aus Silicium oder Siliciumoxid oder Siliciumnitrid besteht.

10. Verfahren zur Herstellung einer Komponente nach einem der Ansprüche 1 bis 7, das die Produktion, bei einer gegebenen Kristallisierungstemperatur, einer Perowskitmaterialschicht zwischen einer unteren Elektrode und einer oberen Elektrode beinhaltet, wobei die Produktion der unteren Elektrode die folgenden Schritte beinhaltet:
Erzeugen eines ersten Stabilisierungsschicht durch Absetzen von Platin bei einer ersten Höchsttemperatur (T1);
Erzeugen einer zweiten Keimungsschicht durch Absetzen von Platin bei einer zweiten Höchsttemperatur (T2), niedriger als die erste Temperatur (T1) und auf der Kristallisierungstemperatur des Perowskitmaterials.

11. Verfahren zur Herstellung einer Komponente nach Anspruch 10, **dadurch gekennzeichnet, dass** die erste Temperatur (T1) gleich oder höher ist als die Kristallisierungstemperatur des Perowskitmaterials.

12. Verfahren zur Herstellung einer Komponente nach Anspruch 10 oder 11, **dadurch gekennzeichnet, dass** das Perowskitmaterial aus PZT mit der Orientierung (100) mit einer Kristallisierungstemperatur gleich oder höher als 500°C ist;
die Erzeugung einer ersten Stabilisierungsschicht durch Absetzen von Platin bei einer ersten Höchsttemperatur (T1) in der Ordnung von 700°C erfolgt;
die Erzeugung einer als Keimungsschicht dienenden zweiten Schicht durch Absetzen von Platin bei einer zweiten Höchsttemperatur (T2) unterhalb von etwa 200°C erfolgt, die in der Ordnung von 25°C liegen kann.

13. Verfahren zur Herstellung einer Komponente nach Anspruch 10, **dadurch gekennzeichnet, dass** das Perowskitmaterial aus PZT mit der Orientierung (111) mit einer Kristallisierungstemperatur gleich oder höher als 500°C ist;
die Erzeugung einer ersten Stabilisierungsschicht durch Absetzen von Platin bei einer ersten Höchsttemperatur (T1) in der Ordnung von 700°C erfolgt;
die Erzeugung einer zweiten Keimungsschicht durch Absetzen von Platin bei einer zweiten Höchsttemperatur (T2) unter etwa 500°C erfolgt, die in der Ordnung von 450°C liegen kann.

14. Verfahren zur Herstellung einer Komponente nach einem der Ansprüche 10 bis 13, **dadurch gekennzeichnet, dass** die erste Schicht bei einer Absetztemperatur erzeugt und bei einer Glühtemperatur geglüht wird.

15. Verfahren zur Herstellung einer Komponente nach Anspruch 14, **dadurch gekennzeichnet, dass** die Absetztemperatur 450°C und die Glühtemperatur 700°C beträgt.

## Claims

1. An electrical component comprising a layer of lead-based perovskite crystal material between a lower electrode (Eᵢ) on the surface of a substrate (S) and an upper electrode (Eₛ), said lower electrode comprising a first stabilisation layer (Eᵢ₁) made from a first material and a second germination layer (Eᵢ₂) made from a second material, **characterised in that** said first and second materials have the same chemical composition but have different structural parameters and/or densities.

2. The electrical component according to claim 1, **characterised in that** said first stabilisation layer is in contact with said second germination layer.

3. The electrical component according to claim 1 or 2, **characterised in that** said perovskite material is one of the following materials: doped or non-doped PZT, PbZrO₃, PbTiO₃, Pb(Mn,Nb)O₃, Pb(Mn,Nb)O₃-PbTiO₃.

4. The electrical component according to any one of claims 1 to 3, **characterised in that** said first stabilisation layer and said second germination layer of said lower electrode are respectively made from platinum.

5. The electrical component according to any one of claims 1 to 4, **characterised in that** said perovskite material is made from PZT of crystallographic orientation (111).

6. The electrical component according to any one of claims 1 to 4, **characterised in that** said perovskite material is made from PZT of crystallographic orientation (100).

7. An actuator comprising an electronic component according to any one of claims 1 to 6, wherein said substrate comprises at least one recessed part so as to define a free zone capable of deforming that comprises the layer of perovskite material.

8. The actuator according to claim 7, **characterised in that** it further comprises an elastic layer on the surface of said substrate, onto which said stabilisation layer is deposited, positioned at least above said recessed part.

9. The actuator according to claim 8, **characterised in that** said elastic layer is made from silicon or silicon oxide or silicon nitride.

10. A method for manufacturing a component according to any one of claims 1 to 7, comprising the production, at a given crystallisation temperature, of a layer of perovskite material between a lower electrode and an upper electrode, said production of said lower electrode comprising the following steps:
producing a first stabilisation layer carried out by depositing platinum at a first maximum temperature (T1);
producing a second germination layer carried out by depositing platinum at a second maximum temperature (T2), below said first temperature (T1), and at the crystallisation temperature of the perovskite material.

11. The method for manufacturing a component according to claim 10, **characterised in that** said first temperature (T1) is higher than or equal to the crystallisation temperature of the perovskite material.

12. The method for manufacturing a component according to any one of claims 10 to 11, **characterised in that** said perovskite material is made from PZT of orientation (100), the crystallisation temperature of which is higher than or equal to 500°C;
the production of a first stabilisation layer is carried out by depositing platinum at a first maximum temperature (T1) of the order of 700°C;
the production of a second layer acting as a germination layer is carried out by depositing platinum at a second maximum temperature (T2) below approximately 200°C, and which can be of the order of 25°C.

13. The method for manufacturing a component according to claim 10, **characterised in that** said perovskite material is of PZT orientation (111), the crystallisation temperature of which is higher than or equal to 500°C;
the production of a first stabilisation layer is carried out by depositing platinum at a first maximum temperature (T1) of the order of 700°C;
the production of a second germination layer is carried out by depositing platinum at a second maximum temperature (T2) below approximately 500°C, which can be of the order of 450°C.

14. The method for manufacturing a component according to any one of claims 10 to 13, **characterised in that** said first layer is produced at a depositing temperature and annealed at an annealing temperature.

15. The method for manufacturing a component according to claim 14, **characterised in that** the depositing temperature is 450°C, with the annealing temperature being 700°C.
